Europäisches Patentamt

European Patent Office

Office européen des brevets

(11) Veröffentlichungsnummer: **0 477 392 A1**

(12) **EUROPÄISCHE PATENTANMELDUNG**

(21) Anmeldenummer: **90118325.1**

(22) Anmeldetag: **24.09.90**

(51) Int. Cl.5: **H01L  27/02**

(43) Veröffentlichungstag der Anmeldung:
**01.04.92 Patentblatt  92/14**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Becker Burkhard, Dr.rer.nat.**
**Schlüsselbergstrasse 8**
**W-8000 München 80(DE)**

(54) **Eingangsschutzstruktur für integrierte Schaltungen.**

(57) Eine Eingangsschutzstruktur für integrierte Schaltungen mit einer Oxid-Isolation benachbarter Bauelemente, die durch Verschalten von zwei Transistoren (3, 4) zu einem Thyristor gebildet ist, soll einen hohen Schutz gegen elektrostatische Entladungen insbesondere auch im Falle einer fehlenden Versorgungsspannung (Us) gewährleisten. Zu dem Thyristor (3, 4) ist mindestens ein zusätzlicher Transistor (5) parallel geschaltet, und die Basis des Transistors (5) ist mit einem Anschluß für ein Versorgungspotential (Us) verbunden.

FIG 1

EP 0 477 392 A1

Die Erfindung betrifft eine Eingangsschutzstruktur für integrierte Schaltungen nach dem Oberbegriff des Anspruchs 1.

Integrierte Schaltungen benötigen einen sicheren Schutz gegen elektrostatische Entladungen (ESD). Zu diesem Zweck werden sie mit Eingangsschutzstrukturen versehen. Derartige Eingangsschutzstrukturen, die einen Thyristor enthalten, sind bekannt und beispielsweise in der DE-OS 32 10 743 beschrieben. Allerdings werden solche Eingangsschutzstrukturen bei bipolaren integrierten Schaltungen verwendet, bei denen benachbarte Bauelemente durch eine sogenannte PN-Isolation voneinander isoliert sind.

Gegenstand eines älteren Vorschlages (Europäische Patentanmeldung Nr. 89122102.0) ist außerdem eine Eingangsschutzstruktur für integrierte Schaltungen mit einer Oxid-Isolation benachbarter Bauelemente, die durch einen Thyristor, einen integrierten Widerstand und eine spezielle Anordnung und Struktur der den Thyristor bildenden Zonen in einem Halbleitersubstrat eine hohe Belastbarkeit gegen elektrostatische Entladungen ermöglicht.

Der Erfindung liegt die Aufgabe zugrunde, eine Eingangsschutzstruktur für bipolare integrierte Schaltungen mit einer Isolation benachbarter Bauelemente durch Oxid-Gebiete zu schaffen, die einen hohen Schutz gegen elektrostatische Entladungen insbesondere auch im Fall einer fehlenden Versorgungsspannung gewährleistet.

Diese Aufgabe wird erfindungsgemäß durch eine Eingangsschutzstruktur mit den Merkmalen des Anspruchs 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß die ESD-Schutzstruktur aus einem Thyristor und einem Substrat-pnp-Transistor in einer integrierten Form gebildet ist, welche zum einen die Ableitung von positiven Impulsen gegenüber einem einzelnen Substrat-pnp-Transistor verbessert und zum anderen den Schutz von integrierten Schaltungen auch im Fall einer fehlenden Versorgungsspannung gewährleistet. Diese ist lediglich zur Sperrung des Emitter-Basis-Übergangs des Substrat-pnp-Transistors im Betrieb erforderlich.
Für negative Spannungen übernimmt der Thyristor die Aufgabe einer Buried Layer(BL)-Substrat-Diode. Somit ist die erfindungsgemäße Eingangsschutzstruktur auch einer bislang verwendeten Standartstruktur aus Substrat-pnp-Transistor und BL-Substrat-Diode überlegen.

Anhand eines in den Figuren der Zeichnung dargestellten Ausführungsbeispiels wird die Erfindung im folgenden näher erläutert.

Es zeigen

FIG 1 ein Ersatzschaltbild einer Eingangsschutzstruktur und

FIG 2 eine schematische Darstellung einer Eingangsschutzstruktur nach FIG 1.

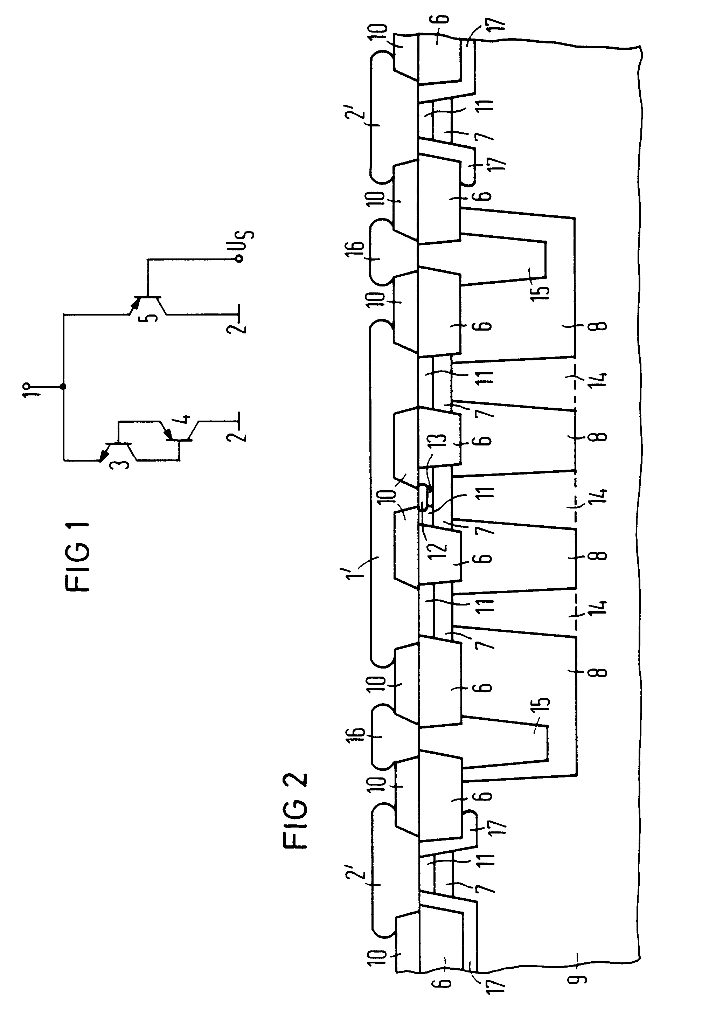

Gemäß FIG 1 liegt zwischen einem Eingangsanschluß 1 einer integrierten Schaltung und einem Bezugspotential 2, insbesondere Erdpotential, eine Schutzstruktur, die vorzugsweise durch einen npn-Transistor 3 und einen pnp-Transistor 4, die zu einem npnp-Thyristor gekoppelt sind, und einen Substrat-pnp-Transistor 5, der zu dem npnp-Thyristor parallel geschaltet ist, gebildet ist.

Der npnp(Substrat)-Thyristor weist vorzugsweise die Schichtenfolge Emitter (n) -, Basis (p) - Epitaxie (n) - bzw. Buried Layer (n$^+$) - Diffusion, Substrat (p) auf.
Der parallel geschaltete Substrat-pnp-Transistor hat vorzugsweise die Schichtenfolge Basis-Kontakt (p) -, Epitaxie (n) - bzw. Buried Layer (n$^+$) - Diffusion, Substrat (p), wobei die Basis der Substrat-pnp-Transistoren 4, 5, d.h. das n-Epitaxiegebiet bzw. die n$^+$-Buried Layer-Diffusionszone mit einer positiven Versorgungsspannung Us verbunden ist.

Der technologische Aufbau der Eingangsschutzstruktur ist in FIG 2 dargestellt. Der Schichtaufbau des aus dem npn-Transistor 3 und dem pnp-Transistor 4 gebildeten npnp-Thyristors 3, 4 sowie des parallel geschalteten Substrat-pnp-Transistors 5 wird in voneinander durch Oxid-Isolationszonen 6 isolierten Epitaxie-Wannen bzw. Epitaxie-Gebieten 7 verwirklicht, wobei vorteilhafterweise zwei symmetrisch zur Thyristor-Wanne liegende Wannen für den Substrat-pnp-Transistor 5 vorgesehen sind. Die Bauelemente entstehen nach der Diffusion der Buried Layer 8 in das p-Halbleitersubstrat 9, der Epitaxie-Beschichtung zum Erzeugen der in diesem Beispiel n-leitenden Epitaxie-Gebiete 7 und der Oxid-Isolation zum Bilden der Isolationszonen 6, durch die ganzflächige Implantation der Basis 13 sowie durch die Diffusion einer hochdotierten, hier p$^+$-Basis-Kontakt-Zone 11. Der npnp-Thyristor 3, 4 wird zudem durch eine Emitter-Diffusion zum Erzeugen des Emitters 12 vervollständigt, wobei unterhalb des Emitters 12 eine niedrig dotierte Basis-Zone 13 erhalten bleiben muß. Eine Basis-Kontakt-Diffusion ist im Thyristor-Bereich nicht unbedingt erforderlich.

Die Dotierung der einzelnen Schichten, vorzugsweise n- und p-dotierten abgeschiedenen Polysilizium-Schichten für den n-Emitter bzw. den p-Basis-Kontakt, wird in an sich bekannter Weise vorgenommen.

Unterhalb der Epitaxie-Wannen bzw. Epitaxie-Gebiete 7 mit den entsprechenden Bauelementen ist eine Aussparung 14 in der vergrabenen Schicht bzw. Buried Layer 8 zur Verringerung der effektiven Basisweite der pnp-Transistoren 4, 5 angebracht.

Die gemeinsame Basis der pnp-Transsitoren 4, 5, d.h. die Buried Layer-Diffusionszone 8, kann mit Hilfe einer Kollektor-Tief-Diffusions-Zone 15, die vorteilhafterweise zweifach bzw. beidseitig in die Zone 8 eingebracht ist, mit einer positiven Versorgungsspannung Us verbunden werden. In an sich bekannter Weise hergestellte Anschlüsse 16 sorgen für die Beschaltung der Basen 15 der Substrat-pnp-Transistoren 4, 5.

Auf die Oberfläche des Halbleitersystems ist eine isolierende Schicht 10 aufgebracht, die zur Herstellung von Anschlußöffnungen strukturiert wird. Über einen Eingangs-Anschluß 1' sind die Basiskontaktzonen 11 und der Emitter 12 an den Eingang 1 (FIG 1) angeschlossen. Über einen Ausgangs-Anschluß 2' ist das p-Halbleitersubstrat 9 an das vorzugsweise Erdpotential als Bezugspotential angeschlossen. In diesem Beispiel sorgen für die Verbindung des p-Halbleitersubstrats 9 mit dem jeweiligen Ausgangs-Anschluß 2' die hochdotierte p-Basis-Kontaktzone 11 sowie zusätzliche am Rande der Oxid-Isolationszonen 6 in das Substrat 9 hineinreichende hochdotierte p-Bereiche, sogenannte Channelstopperbereiche 17.

Die Schutzwirkung der Eingangsschutzstruktur wird folgendermaßen erzielt:

1. Negative Spannungen werden ausschließlich über den npnp-Thyristor abgeleitet, d.h. das Zünden des Thyristors erfolgt bei negativen Spannungen von einigen Volt mit einer Haltespannung von -0,7V. Eine Versorgungsspannung ist für diesen Fall bedeutungslos.

2. Positive Spannungen werden sowohl über die Thyristorstrecke als auch über den Substrat-pnp-Transistor abgeleitet. Hier müssen je nachdem, ob eine Versorgungsspannung Us angelegt wird oder nicht, zwei Fälle unterschieden werden:

a) Versorgungsspannung nicht vorhanden:
Der Impuls wird hier zusätzlich zur Thyristorstrecke über die Emitter-Kollektor-Strecke des Substrat-pnp-Transistors abgeführt. Hier macht sich der Vorteil der zweifachen Ausführung dieses Transistors bemerkbar. Selbst wenn der Versorgungsanschluß nicht beschaltet ist, kann dennoch je nach den schaltungstechnischen Gegebenheiten eine Ableitung des Impulses über den Umweg über den Versorgungsanschluß zum Substrat hin erfolgen.

b) Versorgungsspannung vorhanden (Baustein im Betrieb):
Die Ableitung erfolgt hier zusätzlich zum überwiegenden Teil über den für hohe positive Impulse in Durchlaß geschalteten Emitter-Basis-Übergang (Basiskontaktzone-Buried Layer) des Substrat pnp-Transistors.

**Patentansprüche**

1. Eingangsschutzstruktur für integrierte Schaltungen, die in einem Halbleitersubstrat zwischen einen Eingang und einen Ausgang für ein Bezugspotential geschaltet ist, die mindestens einen ersten und einen zweiten Transistor enthält, welche zu einem Thyristor gekoppelt sind, und die eine Oxid-Isolation benachbarter Bauelemente aufweist, **dadurch gekennzeichnet,** daß zu dem Thyristor (3, 4) mindestens ein zusätzlicher Transistor (5) parallel geschaltet ist, und daß die Basis (8) des Transistors (5) mit einem Anschluß (16) für ein Versorgungspotential (Us) verbunden ist.

2. Eingangsschutzstruktur nach Anspruch 1, **dadurch gekennzeichnet,** daß der erste Transistor (3) ein npn-Transistor und der zweite Transistor (4) ein pnp-Transistor ist, die zu einem npnp-Thyristor (3, 4) gekoppelt sind, und daß der zusätzliche Transistor (5) ein Substrat-pnp-Transistor ist.

3. Eingangsschutzstruktur nach Anspruch 1 oder 2, **dadurch gekennzeichnet,** daß die gemeinsame Basis (8) der zusätzlichen pnp-Transistoren (5) mit jeweils einer Kollektor-Tief-Diffusionszone (15) zum Verbinden mit einem positiven Versorgungspotential (Us) versehen ist.

4. Eingangsschutzstruktur nach einem der Ansprüche 1 bis 3, **dadurch gekennzeichnet,** daß zur Verringerung der effektiven Basisweite der pnp-Transistoren (4, 5) jeweils eine Aussparung (14) in einer die Basis (8) bildenden Buried Layer vorgesehen ist.

EP 0 477 392 A1

FIG 1

FIG 2

**Europäisches Patentamt**

**EUROPÄISCHER RECHERCHENBERICHT**

Nummer der Anmeldung

**EP 90 11 8325**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | GB-A-2 218 872   (TEXAS)<br>* Seite 13, Zeile 7 - Seite 23, Zeile 20; Figuren *<br>– – – | 1,2 | H 01 L 27/02 |
| A,D | GB-A-2 095 909   (RCA CORPORATION)<br>* Zusammenfassung; Figuren *<br>– – – | 1,2 | |
| A | EP-A-0 166 932   (TEXAS)<br>* Zusammenfassung; Figuren *<br>– – – | 1,2 | |
| A | US-A-4 633 283   (RCA CORPORATION)<br>* Zusammenfassung; Figuren *<br>– – – – – | 1,2 | |

RECHERCHIERTE SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| Den Haag | 08 Mai 91 | VENDANGE P. |